# EUROPÄISCHE PATENTSCHRIFT

(11) **EP 3 281 286 B1**
(45) Veröffentlichungstag und Bekanntmachung des Hinweises auf die Patenterteilung: **03.10.2018**
(21) Anmeldenummer: 16712882.6
(22) Anmeldetag: 30.03.2016
(51) Int. Cl.: H02M 1/08, H03K 17/082

(54) **TREIBERSCHALTUNG, SCHALTUNGSANORDNUNG UMFASSEND EINE TREIBERSCHALTUNG UND WECHSELRICHTER UMFASSEND EINE SCHALTUNGSANORDNUNG**
DRIVER CIRCUIT, CIRCUIT ARRANGEMENT COMPRISING A DRIVER CIRCUIT, AND INVERTER COMPRISING A CIRCUIT ARRANGEMENT
CIRCUIT DE COMMANDE, AGENCEMENT DE CIRCUIT COMPORTANT UN CIRCUIT DE COMMANDE ET ONDULEUR COMPORTANT UN AGENCEMENT DE CIRCUIT

(30) Priorität: 04.04.2015 DE 102015105192
(43) Veröffentlichungstag der Anmeldung: 14.02.2018
(73) Patentinhaber: SMA Solar Technology AG, 34266 Niestetal (DE)
(72) Erfinder: MONDZIK, Andrzej, 26-115 Skarzysko Koscielne (PL); PENCZEK, Adam, 30-127 Krakow (PL); RYLKO, Marek, 43-300 Bielsko-Biala (PL); SZOT, Slawomir, 38-400 Krosno (PL); SZAREK, Milosz, 30-126 Krakow (PL); STALA, Robert, 31-623 Krakow (PL)
(86) Internationale Anmeldenummer: PCT/EP2016/056972
(87) Internationale Veröffentlichungsnummer: WO 2016/162250

(56) Entgegenhaltungen:
- US-A1- 2014 091 643
- MC33153 SINGLE IGBT GATE DRIVER, August 2013 (2013-08), XP002756679, in der Anmeldung erwähnt

## Beschreibung

Die Erfindung betrifft eine Treiberschaltung für einen Leistungshalbleiterschalter mit unidirektionaler Durchflussrichtung sowie eine Schaltungsanordnung umfassend eine solche Treiberschaltung und einen Leistungshalbleiterschalter mit unidirektionaler Durchflussrichtung. Weiterhin betrifft die Erfindung eine bidirektionale Schaltungsanordnung umfassend zwei solcher Schaltungsanordnungen sowie einen Wechselrichter mit einer BSNPC-Brückenschaltung umfassend eine entsprechende bidirektionale Schaltungsanordnung.

Zur Erzeugung von Ansteuersignalen für einen Leistungshalbleiterschalter werden häufig digitale Schaltungen, beispielsweise insbesondere Mikroprozessoren, verwendet. Die von digitalen Schaltungen bereit gestellten Ausgangsströme sind in vielen Fällen jedoch nicht ausreichend, um einen Leistungshalbleiterschalter direkt anzusteuern. Daher werden Treiberschaltungen zwischen der digitalen Schaltung und dem Leistungshalbleiterschalter eingesetzt, die einen Strom in erforderlicher Höhe bereitstellen.

Es sind sogenannte Treiberbausteine verfügbar, in denen die für viele Anwendungsfälle wesentlichen Komponenten einer Treiberschaltung bereits integriert sind. Eine Treiberschaltung für einen speziellen Anwendungsfall lässt sich mit einem solchen Treiberbaustein durch Ergänzung und geeignete Dimensionierung diskreter Bauteile, wie Widerstände, Dioden und Kapazitäten, in einer dem Fachmann beispielsweise aus Datenblättern oder Application Notes der Hersteller von Treiberbausteinen bekannten Weise realisieren.

Viele Treiberbausteine stellen über die eigentliche Treiberfunktion hinaus zusätzliche Funktionen zur Verfügung, die dem Schutz des Leistungshalbleiterschalters oder des Treiberbausteins vor Zerstörung durch zu hohe Spannungen oder Ströme in bestimmten ungewollten Betriebssituationen dienen. Sehr verbreitet sind beispielsweise Treiberbausteine mit einem Überspannungsüberwachungseingang für das sogenannte "Desaturation Monitoring" (DESAT), wodurch im Fall einer zu hohen Spannung zwischen einem gesteuerten Anschluss und einem Bezugspotentialanschluss des geschlossenen Leistungshalbleiterschalters der Leistungshalbleiterschalter über eine entsprechende Ansteuerung durch den Treiberbaustein geöffnet wird.

Aus dem Datenblatt "MC33153 Single IGBT Gate Driver", August, 2013 - Rev. 8, MC33153/D der Firma Semiconductor Components Industries, LLC ist beispielsweise ein Treiberbaustein bekannt, der einen Überspannungsüberwachungseingang für das "Desaturation Monitoring" (DESAT) aufweist. Hierbei wird der DESAT-Eingang über einen optionalen Widerstand und eine Diode mit dem gesteuerten Anschluss eines Leistungshalbleiterschalters verbunden, wobei weiterhin eine Kapazität zwischen dem DESAT-Eingang und dem Bezugspotentialanschluss des Leistungshalbleiterschalters angeordnet ist. Weiterhin sind aus dem Datenblatt auch verschiedene Möglichkeiten der Verbindung eines Steuerausgangs des Treiberbausteins mit einem Steueranschluss des Leistungshalbleiterschalters bekannt.

Die Application Note 5324 "Desaturation Fault Detection", AV02-0258EN - June 1, 2007 der Firma Avago Technologies Limited offenbart für verschiedene Treiberbausteine jeweils die gleiche Beschaltung eines DESAT-Eingangs wie das zuvor genannte Datenblatt der Firma Semiconductor Components Industries, LLC.

Die gleiche Form der Beschaltung eines DESAT-Eingangs wird auch bei dem Treiberbaustein in der Application Note AN1944 "Developing IGBT applications using an TD350 advanced IGBT driver", Rev. 4, 09-Oct-2006 der Firma STMicroelectronics offenbart. Der hierin gezeigte Treiberbaustein weist darüber hinaus einen jeweils getrennten Steuerausgang zum Ein- und Ausschalten eines Leistungshalbleiterschalters auf.

Die Druckschrift US 2009/0153223 A1 offenbart eine Treiberschaltung für einen IGBT, der einen Steueranschluss, einen Bezugspotentialanschluss und einen gesteuerten Anschluss aufweist. Die Treiberschaltung umfasst eine Entsättigungsschaltung bestehend aus einer Reihenschaltung eines Schalters, einer Spannungsquelle und einer Diode, wobei die Entsättigungsschaltung zwischen dem gesteuerten Anschluss des IGBTs und einem dem Steueranschluss des IGBTs zugewandten Ende eines Gatewiderstands angeschlossen ist. In Ausführungsformen der Treiberschaltung ist die Spannungsquelle durch einen Kondensator ausgebildet, der bei ausgeschaltetem IGBT geladen wird. Der Schalter wird vor dem Ausschalten des IGBTs geschlossen, wobei der IGBT dann mit einer vorgegebenen zeitlichen Verzögerung nach dem Schließen des Schalters ausgeschaltet wird. Eine regelmäßig bei Treiberschaltungen mit Entsättigungsüberwachung vorgesehene Kapazität zwischen einem Punkt, der die Spannungsquelle mit der Diode verbindet, und dem am Bezugspotentialanschluss anliegenden Bezugspotential ist bei der Treiberschaltung in der US 2009/0153223 A1 nicht vorgesehen.

In der Druckschrift US 2014/0091643 A1 ist eine Treiberschaltung mit einer speziell für ein Desaturation Monitoring eines selbstleitenden Leistungshalbleiterschalters eingerichteten Überwachungsschaltung offenbart. Die Überwachungschaltung weist ein Netzwerk von geschalteten Kapazitäten auf, bei dem mehrere Kapazitäten durch gezieltes Schließen und Öffnen von Schaltern geladen bzw. entladen werden oder Ladungen zwischen den Kapazitäten umgeladen werden. Aufgrund des Netzwerks von geschalteten Kapazitäten liegt bei der in der Druckschrift US 2014/0091643 A1 offenbarten Treiberschaltung unter anderem ein durch ein aktiv ansteuerbares Schaltelement schaltbarer Verbindungspfad von einem mit einem Bezugspotentialanschluss des Leistungshalbleiterschalters verbundenen Punkt über eine Kapazität und eine Diode zu einem mit einem gesteuerten Anschluss des Leistungshalbleiterschalters verbundenen Punkt vor.

Leistungshalbleiterschalter weisen häufig eine antiparallele Diode entweder in Form einer intrinsischen Diode, beispielsweise einer Bodydiode, oder einer zusätzlich innerhalb oder außerhalb eines Leistungshalbleitermoduls angebrachten Diode auf. Falls keine solche antiparallele Diode vorhanden ist, das heißt bei einem Leistungshalbleiterschalter mit unidirektionaler Durchflussrichtung, beispielsweise bei sogenannten Reverse Blocking IGBTs, kann das Potential am Bezugspotentialanschluss des Leistungshalbleiterschalters höher sein als am gesteuerten Anschluss, womit bei einer praxisüblichen Beschaltung in der Form wie in dem zuvor genannten Datenblatt bzw. den zuvor genannten Application Notes ein unerwünschter Strom von dem Bezugspotentialanschluss zum gesteuerten Anschluss fließt, der zu einer Zerstörung von Komponenten der Treiberschaltung führen kann.

Reverse Blocking IGBTs finden, insbesondere als bidirektionale Schaltungsanordnung, bei der zwei Reverse Blocking IGBTs antiparallel geschaltet sind, beispielsweise Anwendung im Neutralzweig eines BSNPC-Wechselrichters (Bipolar Switch Neutral Point Clamped), auch bekannt als NPC-2 Wechselrichter. Ein solcher BSNPC-Wechselrichter mit einem aus antiparallel geschalteten Reverse Blocking IGBTs gebildeten bidirektionalen Schalter ist beispielsweise in der Druckschrift WO 2013/145854 A1 offenbart. Für jeden der IGBTs ist eine Treiberschaltung vorhanden, wobei für die Treiberschaltungen jeweils keine Maßnahmen für eine Entsättigungsüberwachung vorgesehen sind.

In der Schrift "Application of Gate Drivers for 3-Level NPC-2 Power Modules with Reverse Blocking IGBTs", PCIM ASIA, Shanghai, China, 17-19 June 2014, von C. Dustert und A. Volke wird vorgeschlagen, bei Verwendung von Reverse Blocking IGBTs im Neutralzweig eines NPC-2 Wechselrichters anstelle der Diode in der Beschaltung des DESAT-Eingangs eine Widerstandskette vorzusehen, womit einerseits weiterhin die DESAT Monitoring Funktionalität gewährleistet ist, aber andererseits keine gefährlich hohen Ströme mehr fließen können. Nachteilig ist hierbei, dass nach wie vor immer noch ein unerwünschter Strom von dem Bezugspotentialanschluss zum gesteuerten Anschluss fließt, wenn das Potential am Bezugspotentialanschluss des Leistungshalbleiterschalters höher ist als am gesteuerten Anschluss, was zumindest unerwünschte Leistungsverluste zur Folge hat.

Es ist daher eine Aufgabe der vorliegenden Erfindung, eine Treiberschaltung bereitzustellen, bei der bei Beschaltung eines Überspannungsüberwachungseingangs eines Treiberbausteins zur Realisierung eines Desaturation Monitorings das Auftreten unerwünschter Ströme zuverlässig verhindert wird, ohne dabei ungewollte Leistungsverluste in Kauf nehmen zu müssen.

Diese Aufgabe wird erfindungsgemäß gelöst durch eine Treiberschaltung gemäß dem unabhängigen Anspruch 1, durch eine Schaltungsanordnung gemäß dem nebengeordneten Vorrichtungsanspruch 10 sowie durch eine bidirektionale Schaltungsanordnung gemäß dem nebengeordneten Vorrichtungsanspruch 12. Anspruch 14 ist auf einen Wechselrichter gerichtet, der eine solche erfindungsgemäße bidirektionale Schaltungsanordnung umfasst. Vorteilhafte Ausgestaltungen der Erfindung sind in den abhängigen Ansprüchen beschrieben.

Eine erfindungsgemäße Treiberschaltung für einen Leistungshalbleiterschalter mit unidirektionaler Durchflussrichtung, das heißt für einen Leistungshalbleiterschalter, für den ein Stromfluss entgegen der Durchflussrichtung gesperrt ist, umfasst einen Treiberbaustein, der einen Steuerausgang, einen Bezugspotentialeingang und einen Überspannungsüberwachungseingang aufweist. Dabei ist der Steuerausgang mit einem ersten Anschluss der Treiberschaltung verbunden, der zur Verbindung mit einem Steueranschluss des Leistungshalbleiterschalters vorgesehen ist. Der Bezugspotentialeingang ist mit einem zweiten Anschluss verbunden, der zur Verbindung mit einem Bezugspotentialanschluss des Leistungshalbleiterschalters vorgesehen ist, und der Überspannungsüberwachungseingang ist über eine erste Diode mit einem dritten Anschluss verbunden, der zur Verbindung mit einem gesteuerten Anschluss des Leistungshalbleiterschalters vorgesehen ist. Ferner ist bei der erfindungsgemäßen Treiberschaltung der Überspannungsüberwachungseingang über eine Kapazität mit dem Bezugspotentialeingang verbunden.

Bei dieser Verschaltung des Treiberbausteins mit dem ersten, zweiten und dritten Anschluss existiert ein Verbindungspfad von dem zweiten Anschluss zu dem dritten Anschluss über die Kapazität und die erste Diode. Der Verbindungspfad ist bei der erfindungsgemäßen Treiberschaltung durch ein aktiv ansteuerbares Schaltelement schaltbar. Dieser Lösung liegt die Überwindung des Vorurteils zugrunde, dass zur Überwachung der Spannung zwischen dem gesteuerten Anschluss des Leistungshalbleiterschalters und dem Bezugspotentialanschluss des Leistungshalbleiterschalters einerseits der Überspannungsüberwachungseingang permanent über eine Diode oder alternativ über eine Widerstandskette mit dem gesteuerten Anschluss und somit auch permanent über die Diode oder alternativ über die Widerstandskette mit dem dritten Anschluss der Treiberschaltung verbunden sein muss und andererseits der Bezugspotentialeingang permanent mit dem Bezugspotentialanschluss und somit auch mit dem zweiten Anschluss der Treiberschaltung verbunden sein muss. Vielmehr ist aber eine Überspannungsüberwachung eines an die Treiberschaltung angeschlossenen Leistungshalbleiterschalters, und somit die zuvor genannten Verbindungen, nur erforderlich, wenn der Leistungshalbleiterschalter eingeschaltet ist, wohingegen unerwünschte Ströme in dem Verbindungspfad nur fließen können, wenn der Leistungshalbleiterschalter ausgeschaltet ist.

Bevorzugt ist der Treiberbaustein der erfindungsgemäßen Treiberschaltung dazu eingerichtet, ein an dem Bezugspotentialeingang anliegendes Bezugspotential oder ein an einem Steuerpotentialeingang des Treiberbausteins anliegendes Steuerpotential an den Steuerausgang anzulegen. Dabei kann der Steuerausgang, an den die beiden unterschiedlichen Potentiale angelegt werden, ein und derselbe Steuerausgang sein. Es können aber auch zwei Steuerausgänge vorhanden sein, wobei dann an den ersten Steuerausgang das Steuerpotential angelegt wird, während der zweite Steuerausgang hochohmig ist, und an den zweiten Steuerausgang das Bezugspotential angelegt wird, während der erste Steuerausgang hochohmig ist.

Ebenso bevorzugt ist der Treiberbaustein dazu eingerichtet, ein Überschreiten eines innerhalb des Treiberbausteins eingestellten Schwellwerts durch eine an dem Überspannungsüberwachungseingang gegenüber dem Bezugspotential anliegende Spannung zu erkennen. Im Zusammenhang mit der Verbindung des Überspannungsüberwachungseingangs mit dem dritten Anschluss über die erste Diode kann dann beispielsweise ein Desaturation Monitoring durchgeführt werden, indem an dem Überspannungsüberwachungseingang hochohmig eine Spannung gegenüber dem Bezugspotential angelegt wird, beispielsweise durch eine separate Stromquelle oder bevorzugt direkt durch den Treiberbaustein, die größer ist als der Schwellwert. Solange die Spannung zwischen dem gesteuerten Anschluss und dem Bezugspotentialanschluss eines an dem dritten Anschluss und dem zweiten Anschluss der Treiberschaltung angeschlossen Leistungshalbleiterschalters keine gefährlich hohen Werte annimmt, wird über die erste Diode die gegenüber dem Bezugspotential am Überspannungsüberwachungseingang anliegende Spannung auf null, bzw. genau genommen auf die Durchlassspannung des Leistungshalbleiterschalters geklemmt.

Anstatt nur über die erste Diode kann der Überspannungsüberwachungseingang in einer Ausführungsform der erfindungsgemäßen Treiberschaltung auch über eine Reihenschaltung aus einem ersten Widerstand und der ersten Diode mit dem dritten Anschluss verbunden sein. Der erste Widerstand begrenzt den Stromfluss bei Auftreten transienter Spannungsspitzen während Schaltvorgängen des Leistungshalbleiterschalters und dient damit zum Schutz des Treiberbausteins.

Optional kann bei der Treiberschaltung zwischen dem Bezugspotentialeingang und dem Überspannungsüberwachungseingang eine zweite Diode und zwischen dem Überspannungsüberwachungseingang und dem Steuerpotentialeingang eine dritte Diode angeordnet sein. Eine solche Anordnung von zwei Dioden dient als Schutzbeschaltung für den Überspannungsüberwachungseingang. Es ergibt sich dadurch ein weiterer Verbindungspfad von dem zweiten Anschluss zu dem dritten Anschluss über die zweite Diode, den ersten Widerstand, sofern vorhanden, und die erste Diode. Da die zweite Diode direkt parallel zu der Kapazität angeordnet ist, ist bei der erfindungsgemäßen Treiberschaltung auch der weitere Verbindungspfad durch das aktiv ansteuerbare Schaltelement schaltbar.

Über den Verbindungspfad, bzw. auch über den weiteren Verbindungspfad, kann ein unerwünschter Stromfluss auftreten, wenn das Potential an dem zweiten Anschluss höher ist als das Potential an dem dritten Anschluss. Daher ist bei einer Ausführungsform der erfindungsgemäßen Treiberschaltung eine Steuereinrichtung vorgesehen, die dazu eingerichtet ist, das Schaltelement zu öffnen, wenn das Potential an dem zweiten Anschluss höher ist als das Potential an dem dritten Anschluss.

Wie bereits erwähnt, ist eine Überwachung der Spannung zwischen dem gesteuerten Anschluss und dem Bezugspotentialanschluss eines an die Treiberschaltung angeschlossenen Leistungshalbleiterschalters nur erforderlich, während der Leistungshalbleiterschalter eingeschaltet ist. Daher ist die Steuereinrichtung in einer weiteren Ausführungsform der Treiberschaltung alternativ oder zusätzlich dazu eingerichtet, das Schaltelement zu schließen, wenn an dem Steuerausgang das Steuerpotential anliegt.

Im Umkehrschluss ist eine Überwachung der Spannung zwischen dem gesteuerten Anschluss und dem Bezugspotentialanschluss eines an die Treiberschaltung angeschlossenen Leistungshalbleiterschalters nicht erforderlich, während der Leistungshalbleiterschalter ausgeschaltet ist. Daraus ergibt sich für eine weitere Ausführungsform der Treiberschaltung, dass die Steuereinrichtung dazu eingerichtet ist, das Schaltelement zu öffnen, wenn an dem Steuerausgang das Bezugspotential anliegt.

Das Schaltelement kann in einem Teil des Verbindungspfads angeordnet sein, der zwischen der Kapazität und dem dritten Anschluss liegt. Ebensogut kann es aber auch in einem Teil des Verbindungspfads angeordnet sein, der zwischen dem zweiten Anschluss und der Kapazität liegt. In dem Fall ist es erforderlich, dass parallel zu dem Schaltelement eine fünfte Diode angeordnet ist, damit beim Ausschalten des Leistungshalbleiterschalters auch bei geöffnetem Schaltelement weiterhin ein Strom vom Steueranschluss des Leistungshalbleiterschalters über den Treiberbaustein zum Bezugspotentialanschluss des Leistungshalbleiterschalters fließen kann. Grundsätzlich ist auch die Verwendung mehr als eines Schaltelements nicht ausgeschlossen, wobei die Schaltelemente dann auch in jeweils verschiedenen Teilen des Verbindungspfads liegen können.

In einer Ausführungsform der erfindungsgemäßen Treiberschaltung ist das Schaltelement ein Halbleiterschalter, der einen Ansteuereingang aufweist, wobei sich eine weitere Ausgestaltung ergibt, bei der der Ansteuereingang mit dem Steuerausgang des Treiberbausteins verbunden ist.

Eine erfindungsgemäße Schaltungsanordnung umfasst neben der bereits beschriebenen Treiberschaltung einen Leistungshalbleiterschalter mit unidirektionaler Durchflussrichtung, wobei der erste Anschluss mit dem Steueranschluss, der zweite Anschluss mit dem Bezugspotentialanschluss und der dritte Anschluss mit dem gesteuerten Anschluss des Leistungshalbleiterschalters verbunden ist. Der Leistungshalbleiterschalter kann hierbei beispielsweise ein IGBT ohne antiparallele Diode sein. Solche IGBTs sind auch als sogenannte Reverse Blocking IGBTs bekannt.

Zwei solcher Schaltungsanordnungen, bei denen die Leistungshalbleiterschalter der beiden Schaltungsanordnungen antiparallel geschaltet sind, bilden Teilschaltungsanordnungen einer erfindungsgemäßen bidirektionalen Schaltungsanordnung, bei der ein Stromfluss durch entweder den einen unidirektionalen Leistungshalbleiterschalter oder den anderen unidirektionalen Leistungshalbleiterschalter, also in beide Richtungen möglich ist. Dabei sind die beiden Steuereinrichtungen der Teilschaltungsanordnungen bevorzugt derart eingerichtet, dass die Schaltelemente der Teilschaltungsanordnungen komplementär zueinander geöffnet und geschlossen werden.

Eine antiparallele Verschaltung zweier unidirektionaler Leistungshalbleiterschalter, beispielsweise zweier Reverse Blocking IGBTs, findet zum Beispiel Anwendung als bidirektionaler Schalter im Neutralzweig einer BSNPC-Brückenschaltung eines Wechselrichters. Dementsprechend umfasst ein erfindungsgemäßer Wechselrichter mit einer BSNPC-Brückenschaltung eine erfindungsgemäße bidirektionale Schaltungsanordnung.

Im Folgenden wird die Erfindung anhand von Figuren näher erläutert. Die Figuren dienen hierbei der Veranschaulichung von Ausführungsformen der Erfindung, beschränken die Erfindung aber nicht auf die gezeigten Merkmale.
Fig. 1 zeigt eine Treiberschaltung und eine Schaltungsanordnung nach dem Stand der Technik,
Fig. 2 zeigt eine erfindungsgemäße Treiberschaltung in einer erfindungsgemäßen Schaltungsanordnung,
Fig. 3 zeigt eine weitere Ausführungsform einer erfindungsgemäßen Schaltungsanordnung, und
Fig. 4 zeigt eine erfindungsgemäße bidirektionale Schaltungsanordnung.

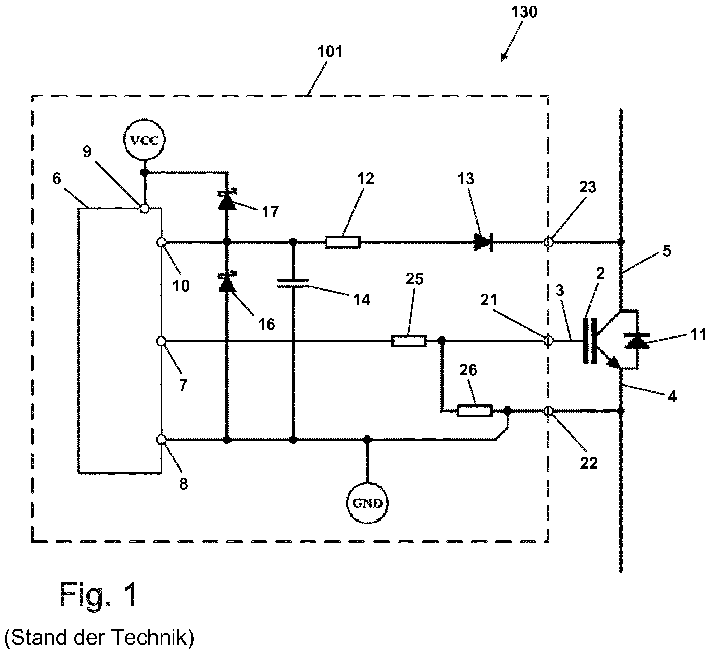

Fig. 1 zeigt eine Treiberschaltung 101 nach dem Stand der Technik für einen Leistungshalbleiterschalter 2. Die Treiberschaltung 101 ist in einer Schaltungsanordnung 130 über einen ersten Anschluss 21 mit einem Steueranschluss 3 des Leistungshalbleiterschalters 2, über einen zweiten Anschluss 22 mit einem Bezugspotentialanschluss 4 des Leistungshalbleiterschalters 2 und über einen dritten Anschluss mit einem gesteuerten Anschluss 5 des Leistungshalbleiterschalters 2 verbunden. Die Treiberschaltung 101 umfasst hier einen Treiberbaustein 6 mit einem Bezugspotentialeingang 8 zum Anlegen eines Bezugspotentials GND und einem Steuerpotentialeingang 9 zum Anlegen eines Steuerpotentials VCC. Der Treiberbaustein 6 ist dazu eingerichtet, bei einer hier nicht im einzelnen dargestellten Ansteuerung durch beispielsweise eine digitale Schaltung, bevorzugt einen Mikroprozessor, entweder das Bezugspotential GND oder das Steuerpotential VCC an einen Steuerausgang 7 anzulegen. Der Steuerausgang 7 ist über einen Verzögerungswiderstand 25 und den ersten Anschluss 21 mit dem Steueranschluss 3 des Leistungshalbleiterschalters 2 verbunden, und der Bezugspotentialeingang 8 ist über den zweiten Anschluss 22 mit dem Bezugspotentialanschluss 4 des Leistungshalbleiterschalters 2 verbunden, so dass in dem Fall, dass an dem Steuerausgang 7 das Steuerpotential VCC anliegt, eine Spannung zwischen dem Steueranschluss 3 und dem Bezugspotentialanschluss 4 anliegt, wodurch der Leistungshalbleiterschalter 2 geschlossen wird und ein Strom von dem gesteuerten Anschluss 5 zu dem Bezugspotentialanschluss 4 fließen kann, während in dem Fall, dass an dem Steuerausgang 7 das Bezugspotential GND anliegt, keine Spannung zwischen dem Steueranschluss 3 und dem Bezugspotentialanschluss 4 anliegt, so dass der Leistungshalbleiterschalter 2 geöffnet wird und kein Strom mehr von dem gesteuerten Anschluss 5 zu dem Bezugspotentialanschluss 4 fließen kann. Über den Verzögerungswiderstand 25 kann in Verbindung mit einer intrinsischen Kapazität zwischen dem Steueranschluss 3 und dem Bezugspotentialanschluss 4 eine Verzögerungszeit beim Ein- und Ausschalten des Leistungshalbleiterschalters 2 eingestellt werden. Zusätzlich ist bei der Treiberschaltung 101 zwischen dem Steueranschluss 3 und dem Bezugspotentialanschluss 4 ein Pull-Down-Widerstand 26 vorhanden, um das Potential am Steueranschluss 3 während der Inbetriebnahme des Treiberbausteins 6 auf das Bezugspotential GND zu ziehen.

Der Treiberbaustein 6 verfügt ferner über einen Überspannungsüberwachungseingang 10, der über einen optionalen ersten Widerstand 12, eine erste Diode 13 und den dritten Anschluss 23 mit dem gesteuerten Anschluss 5 des Leistungshalbleiterschalters 2 verbunden ist. Durch den Treiberbaustein 6 wird an dem Überspannungsüberwachungseingang 10 durch eine beispielsweise in dem Treiberbaustein 6 integrierte Stromquelle eine Spannung gegenüber dem Bezugspotential GND angelegt. Solange die Spannung zwischen dem gesteuerten Anschluss 5 und dem Bezugspotentialanschluss 4 des Leistungshalbleiterschalters 2 keine gefährlich hohen Werte annimmt, wird über die erste Diode 13 die gegenüber dem Bezugspotential GND am Überspannungsüberwachungseingang 10 anliegende Spannung gegen null gezogen. Falls hingegen die Spannung zwischen dem gesteuerten Anschluss 5 und dem Bezugspotentialanschluss 4 zu groß wird, liegt an dem Überspannungsüberwachungseingang 10 nicht mehr eine kleine Spannung gegenüber dem Bezugspotential GND vor, sondern die Leerlaufspannung der internen Stromquelle des Treiberbausteins 6. Dies wird beispielsweise durch Vergleich mit einem Schwellwert unter Verwendung eines Komparators innerhalb des Treiberbausteins 6 erkannt, woraufhin dann an den Steuerausgang 7 das Bezugspotential GND anlegt wird, um den Leistungshalbleiter 2 auszuschalten und damit vor Zerstörung zu schützen. Die beschriebene Funktionalität des Treiberbausteins 7 zur Verwendung des Überspannungsüberwachungseingangs 10 ist in vielen Treiberbausteinen in dieser Form implementiert und dem Fachmann bekannt, daher ist sie bei dem Treiberbaustein 6 in Fig. 1 nicht nochmal ausdrücklich illustriert. Alternativ kann es bei anderen Treiberbausteinen auch vorgesehen sein, die Spannung an dem Überspannungsüberwachungseingang 10 gegenüber dem Bezugspotential GND durch eine separate externe Stromquelle bereitzustellen.

Die Spannung am Überspannungsüberwachungseingangs 10 wird erst dann auf null geklemmt, wenn der Leistungshalbleiterschalter 2 sicher eingeschaltet ist. Um zu verhindern, dass transiente Vorgänge während des Einschaltens des Leistungshalbleiterschalters 2 irrtümlich zu einer Wiederausschaltung des Leistungshalbleiterschalters 2 über die zuvor beschriebene Überspannungsüberwachungsfunktion des Treiberbausteins 6 führen, muss die Überspannungsüberwachungsfunktion verzögert aktiviert werden können. Hierzu ist bei der Treiberschaltung 101 eine Kapazität 14 zwischen dem Überspannungsüberwachungseingang 10 und dem Bezugspotentialeingang 8 vorgesehen. Durch den Treiberbaustein wird in der Zeit, in der an dem Steuerausgang 7 das Bezugspotential GND anliegt, also während der Leistungshalbleiterschalter 2 ausgeschaltet ist, auch das Bezugspotential GND an den Überspannungsüberwachungseingang 10 angelegt, wodurch die Kapazität 14 entladen wird. Wenn dann am Steuerausgang 7 das Steuerpotential VCC angelegt wird, also der Leistungshalbleiterschalter 2 eingeschaltet wird, wird zunächst die Kapazität 14 geladen, wodurch die Spannung am Überspannungsüberwachungseingang 10 gegenüber dem Bezugspotential GND erst entsprechend verzögert anliegt.

Bei der Treiberschaltung 101 in Fig. 1 ist zwischen dem Bezugspotentialeingang 8 und dem Überspannungsüberwachungseingang 10 eine zweite Diode 16 und zwischen dem Überspannungsüberwachungseingang 10 und dem Steuerpotentialeingang 9 eine dritte Diode 17 angeordnet. Diese Dioden sind optional und dienen als Schutzbeschaltung für den Überspannungsüberwachungseingang 10.

Der Leistungshalbleiterschalter 2 in der Schaltungsanordnung 130 gemäß Fig. 1 ist hier beispielsweise ein IGBT (Insulated Gate Bipolar Transistor) mit einer antiparallelen vierten Diode 11. Dadurch liegt bei dem Leistungshalbleiterschalter 2 in Fig. 1 nicht nur eine undirektionale Durchflussrichtung von dem gesteuerten Anschluss 5 zu dem Bezugspotentialanschluss 4 vor, sondern es ist auch ein Stromfluss in entgegengesetzter Richtung über die antiparallele vierte Diode 11 möglich, wenn das Potential am Bezugspotentialanschluss 4 des Leistungshalbleiterschalters 2 höher ist als an seinem gesteuerten Anschluss 5.

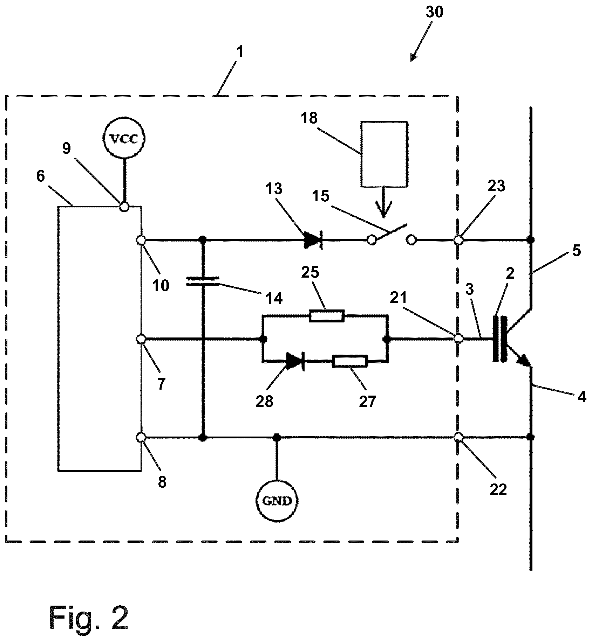

Fig. 2 zeigt eine erfindungsgemäße Treiberschaltung 1 in einer erfindungsgemäßen Schaltungsanordnung 30. Bei der Schaltungsanordnung 30 in Fig. 2 ist ein Leistungshalbleiterschalter 2 mit undirektionaler Durchflussrichtung, hier ein IGBT ohne antiparallele Diode, mit den Anschlüssen 21, 22 und 23 der Treiberschaltung 1 verbunden. Bei der dargestellten erfindungsgemäßen Treiberschaltung 1 ist zwischen der ersten Diode 13 und dem dritten Anschluss 23 ein aktiv ansteuerbares Schaltelement 15 angeordnet. Mit diesem aktiv ansteuerbaren Schaltelement 15 lässt sich ein unerwünschter Stromfluss in einem Verbindungspfad von dem zweiten Anschluss 22 über die Kapazität 14 und die erste Diode 13 selektiv unterbrechen, der aufgrund der unidirektionalen Durchflussrichtung des Leistungshalbleiterschalters 2 auftreten kann, wenn das Potential am Bezugspotentialanschluss 4 höher ist als an dem gesteuerten Anschluss 5. Das aktiv ansteuerbare Schaltelement 15 kann ebensogut an jeder anderen Stelle in dem Verbindungspfad angeordnet sein, beispielsweise zwischen der Kapazität 14 und der ersten Diode 13 oder zwischen dem zweiten Anschluss 22 und der Kapazität 14.

Zur Ansteuerung des Schaltelements 15 ist eine Steuereinrichtung 18 vorgesehen. Dabei kann die Steuereinrichtung 18 so eingerichtet sein, dass das Schaltelement 15 geschlossen wird, wenn an dem Steuerausgang 7 das Steuerpotential VCC anliegt. Die Steuereinrichtung 18 kann aber auch so eingerichtet sein, dass das Schaltelement 15 geöffnet wird, wenn an dem Steuerausgang 7 das Bezugspotential GND anliegt. Unerwünschte Ströme in dem Verbindungspfad, der durch das Schaltelement 15 schaltbar ist, treten nur dann auf, wenn das Potential am Bezugspotentialanschluss 4 des Leistungshalbleiterschalters 2 höher ist als an seinem gesteuerten Anschluss 5. Daher kann in einer weiteren Ausgestaltung die Steuereinrichtung 18 auch so eingerichtet sein, dass das Schaltelement 15 geöffnet wird, wenn das Potential an dem zweiten Anschluss 22 höher ist als das Potential an dem dritten Anschluss 23. Selbstverständlich sind auch Kombinationen der genannten Bedingungen zum Öffnen und Schließen des aktiv ansteuerbaren Schaltelements 15 durch die Steuereinrichtung 18 möglich.

Bei der Treiberschaltung in Fig. 2 ist der Steuerausgang 7 mit dem ersten Anschluss 21 über eine Parallelschaltung des Verzögerungswiderstands 25 und einer Serienverschaltung aus einer fünften Diode 28 mit einem weiteren Verzögerungswiderstand 27 verbunden. Bei dieser Anordnung fließt beim Einschalten des Leistungshalbleiterschalters 2 ein Strom durch die Parallelschaltung des Verzögerungswiderstands 25 und des weiteren Verzögerungswiderstands 27, während beim Ausschalten lediglich ein Strom durch den Verzögerungswiderstand 25 fließt. Damit lassen sich jeweils unterschiedliche Verzögerungszeiten für den Ein- und Ausschaltvorgang einstellen.

Ferner wird bei der Treiberschaltung 1 in Fig. 2 gegenüber der Treiberschaltung aus Fig. 1 exemplarisch auf die optionale zweite Diode 16 und dritte Diode 17 sowie auf den optionalen Pull-Down-Widerstand 26 und den optionalen ersten Widerstand 12 verzichtet.

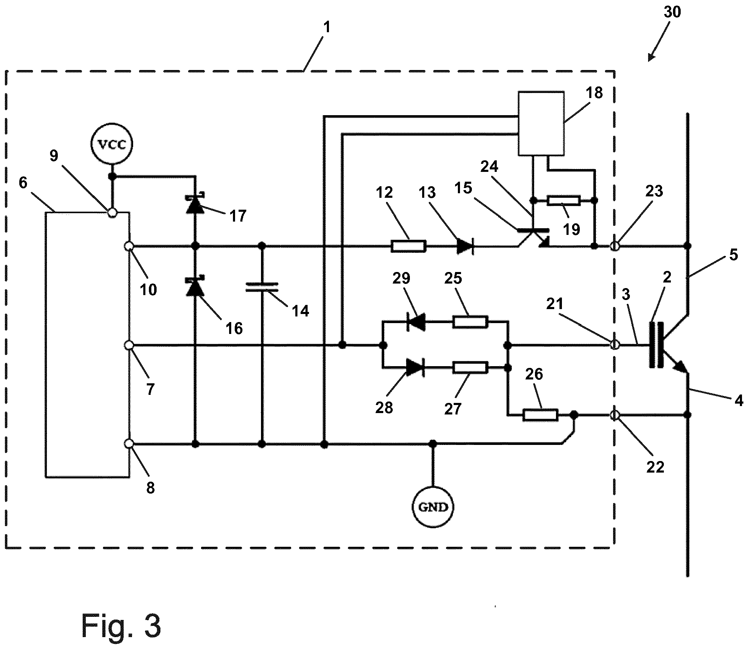

Bei der Ausführungsform der erfindungsgemäßen Schaltungsanordnung 30 gemäß Fig. 3 ist das aktiv ansteuerbare Schaltelement 15 ein Halbleiterschalter, der zwischen der ersten Diode 13 und dem dritten Anschluss 23 angeordnet ist und einen Ansteuereingang 24 aufweist. Der zweite Widerstand 19 dient zum sicheren und schnellen Ausschalten des Halbleiterschalters bei dessen Deaktivierung. Die Steuereinrichtung 18 ist mit dem Steuerausgang 7 und dem Bezugspotentialeingang 8 verbunden und kann dadurch das Potential an dem Steuerausgang 7 auswerten, um das Schaltelement 15 abhängig hiervon zu öffnen oder zu schließen. Darüber hinaus erfüllt die Steuereinrichtung 18 bei dieser Ausführungsform auch die Funktion einer galvanischen Trennung zwischen dem Steuerausgang 7 bzw. dem Bezugspotentialeingang 8 und dem ebenfalls mit der Steuereinrichtung 18 über den dritten Anschluss 23 der Treiberschaltung 1 verbundenen gesteuerten Anschluss 5, an dem bei ausgeschaltetem Leistungshalbleiterschalter 2 gegebenenfalls eine hohe Spannung gegenüber dem Bezugspotential GND anliegt. In dem Ausführungsbeispiel in Fig. 3 ist der Halbleiterschalter ein NPN-Transistor. Ebensogut ist hier auch die Verwendung eine PNP-Transistors oder eines anderen Transistors als Schalter möglich.

Bei der Treiberschaltung in Fig. 3 ist in der Verbindung zwischen dem Steuerausgang 7 und dem ersten Anschluss 21 eine Parallelschaltung einer Serienschaltung aus einer sechsten Diode 29 mit dem Verzögerungswiderstand 25 und einer Serienschaltung aus der fünften Diode 28 mit dem weiteren Verzögerungswiderstand 27 vorhanden, wobei die Dioden 28 und 29 jeweils entgegengesetzte Durchflussrichtung haben. Bei dieser Anordnung fließt beim Ausschalten des Leistungshalbleiterschalters 2 ein Strom durch den Verzögerungswiderstand 25 und beim Einschalten durch den weiteren Verzögerungswiderstand 27. Damit lassen sich jeweils unterschiedliche Verzögerungszeiten für den Ein- und Ausschaltvorgang einstellen.

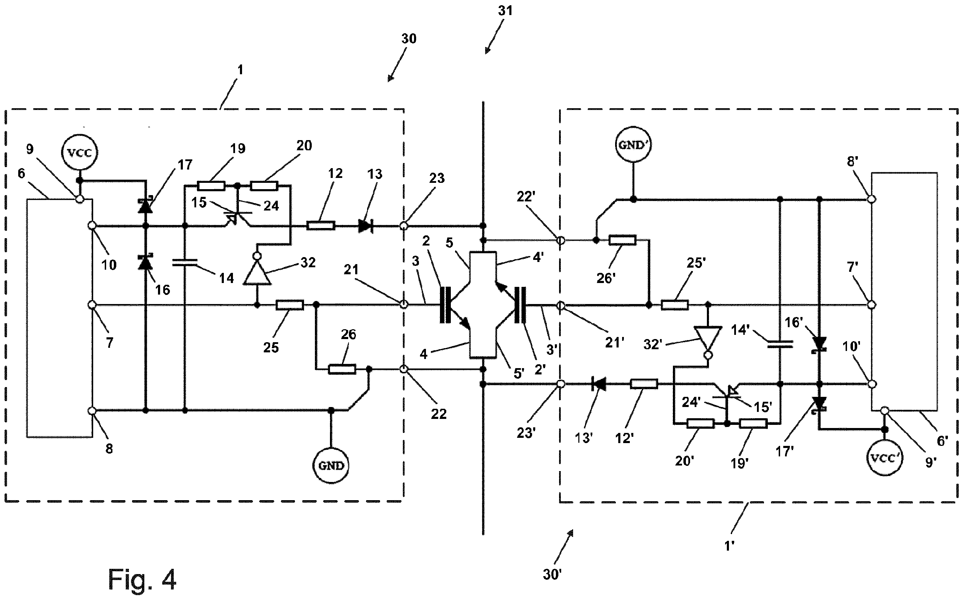

Bei der Treiberschaltung 1 in Fig. 4 ist das aktiv ansteuerbare Schaltelement 15 ebenfalls als Halbleiterschalter mit einem Ansteuereingang 24 ausgebildet und ist hier zwischen der Kapazität 14 und dem ersten Widerstand 12 angeordnet. Aufgrund dieser Anordnung und der Verwendung eines PNP-Transistors ist hier keine Steuereinrichtung 18 mit galvanischer Trennung wie bei dem Ausführungsbeispiel in Fig. 3 mehr erforderlich. Der Ansteuereingang 24 ist über einen Inverter 32 funktional direkt mit dem Steuerausgang 7 des Treiberbausteins 6 verbunden, wodurch das Schaltelement 15 geschlossen wird, wenn an dem Steuerausgang 7 das Steuerpotential VCC anliegt und geöffnet wird, wenn an dem Steuerausgang 7 das Bezugspotential GND anliegt. Der zweite Widerstand 19 dient wieder zum sicheren und schnellen Ausschalten des Halbleiterschalters bei dessen Deaktivierung und der dritte Widerstand 20 dient hier zur Einstellung des Steuerstroms des Halbleiterschalters.

Weiterhin zeigt Fig. 4 insbesondere auch eine erfindungsgemäße bidirektionale Schaltungsanordnung 31, die zwei Teilschaltungsanordnungen umfasst, die jeweils durch eine erfindungsgemäße Schaltungsanordnung 30, 30' gebildet sind. Die Leistungshalbleiterschalter 2, 2' der beiden Teilschaltungsanordnungen sind dabei antiparallel geschaltet, das heißt, die unidirektionalen Durchflussrichtungen der beiden Leistungshalbleiterschalter 2, 2' sind einander entgegengesetzt und ermöglichen es dadurch, bei komplementärer Ansteuerung einen Stromfluss entweder in die eine oder die andere Richtung durchzulassen bzw. bei Ausschalten der beiden Leistungshalbleiterschalter 2, 2' in beide Richtungen zu sperren. Entsprechend ist es auch vorteilhaft, wenn die Steuereinrichtungen 18, 18' der jeweiligen Treiberschaltungen 1, 1' in den Teilschaltungsanordnungen so eingerichtet sind, dass Schaltelemente 15, 15' der Teilschaltungsanordnungen komplementär zueinander geöffnet und geschlossen werden.

Eine antiparallele Verschaltung zweier Leistungshalbleiterschalter mit unidirektionaler Durchflussrichtung zur Realisierung eines bidirektionalen Schalters findet beispielsweise Verwendung im Neutralzweig einer BSNPC-Brückenschaltung in Drei-Level-Wechselrichtern. Dementsprechend ergibt sich auch eine vorteilhafte Verwendung der erfindungsgemäßen bidirektionalen Schaltungsanordnung 31 in einer BSNPC-Brückenschaltung.

Eine erfindungsgemäße bidirektionale Schaltungsanordnung 31 ist nicht auf die in Fig. 4 gezeigte Ausführungsform der Teilschaltungsanordnungen beschränkt. Ebensogut können die Teilschaltungsanordnungen durch Schaltungsanordnungen 30 realisiert sein, wie sie in Fig. 2 oder 3 gezeigt sind sowie auch durch jede andere Form einer erfindungsgemäßen Schaltungsanordnung.

Die Erfindung ist auch nicht auf die explizit gezeigten Ausführungsformen beschränkt, sondern kann in vielfacher Art und Weise abgewandelt, insbesondere mit anderen gezeigten oder dem Fachmann bekannten Ausführungsformen kombiniert werden.

### Bezugszeichenliste

- 1, 1': Treiberschaltung
- 2, 2': Leistungshalbleiterschalter
- 3, 3': Steueranschluss
- 4, 4': Bezugspotentialanschluss
- 5, 5': gesteuerter Anschluss
- 6, 6': Treiberbaustein
- 7, 7': Steuerausgang
- 8, 8': Bezugspotentialeingang
- 9, 9': Steuerpotentialeingang
- 10, 10': Überspannungsüberwachungseingang
- 11, 11': Diode
- 12, 12': Widerstand
- 13, 13': Diode
- 14, 14': Kapazität
- 15, 15': Schaltelement
- 16, 16': Diode
- 17, 17': Diode
- 18, 18': Steuereinrichtung
- 19, 19': Widerstand
- 20, 20': Widerstand
- 21, 21': Anschluss
- 22, 22': Anschluss
- 23, 23': Anschluss
- 24, 24': Ansteuereingang
- 25, 25': Verzögerungswiderstand
- 26, 26': Pull-Down-Widerstand
- 27: Verzögerungswiderstand
- 28: Diode
- 29: Diode
- 30, 30': Schaltungsanordnung
- 31: Bidirektionale Schaltungsanordnung
- 32: Inverter
- 101: Treiberschaltung
- 130: Schaltungsanordnung
- VCC, VCC: Steuerpotential
- GND, GND': Bezugspotential

## Patentansprüche

1. Treiberschaltung (1) für einen Leistungshalbleiterschalter (2) mit unidirektionaler Durchflussrichtung, der einen Steueranschluss (3), einen Bezugspotentialanschluss (4) und einen gesteuerten Anschluss (5) aufweist, wobei die Treiberschaltung (1) einen Treiberbaustein (6) umfasst, der einen Steuerausgang (7), einen Bezugspotentialeingang (8) und einen Überspannungsüberwachungseingang (10) aufweist, und wobei:
- der Steuerausgang (7) mit einem ersten Anschluss (21) verbunden ist, der zur Verbindung mit dem Steueranschluss (3) vorgesehen ist,
- der Bezugspotentialeingang (8) mit einem zweiten Anschluss (22) verbunden ist, der zur Verbindung mit dem Bezugspotentialanschluss (4) vorgesehen ist,
- der Überspannungsüberwachungseingang (10) über eine erste Diode (13) mit einem dritten Anschluss (23) verbunden ist, der zur Verbindung mit dem gesteuerten Anschluss (5) vorgesehen ist, und
- der Überspannungsüberwachungseingang (10) über eine Kapazität (14) mit dem Bezugspotentialeingang (8) verbunden ist,
**dadurch gekennzeichnet, dass**
ein Verbindungspfad von dem zweiten Anschluss (22) zu dem dritten Anschluss (23) über die Kapazität (14) und die erste Diode (13) durch ein aktiv ansteuerbares Schaltelement (15) schaltbar ist, wobei eine Steuereinrichtung (18) vorgesehen ist, die dazu eingerichtet ist, das Schaltelement (15) zu öffnen, wenn das Potential an dem zweiten Anschluss (22) höher ist als das Potential an dem dritten Anschluss (23), und/oder das Schaltelement (15) zu schließen, wenn an dem Steuerausgang (7) ein Steuerpotential (Vcc) anliegt, und/oder das Schaltelement (15) zu öffnen, wenn an dem Steuerausgang (7) ein Bezugspotential (GND) anliegt.

2. Treiberschaltung (1) nach Anspruch 1, wobei der Treiberbaustein (6) dazu eingerichtet ist, wahlweise ein an dem Bezugspotentialeingang (8) anliegendes Bezugspotential (GND) oder ein an einem Steuerpotentialeingang (9) des Treiberbausteins (6) anliegendes Steuerpotential (Vcc) an den Steuerausgang (7) anzulegen.

3. Treiberschaltung (1) nach einem der Ansprüche 1 bis 2, wobei der Treiberbaustein (6) dazu eingerichtet ist, ein Überschreiten eines innerhalb des Treiberbausteins eingestellten Schwellwerts durch eine an dem Überspannungsüberwachungseingang (10) gegenüber dem Bezugspotential (GND) anliegende Spannung zu erkennen.

4. Treiberschaltung (1) nach einem der Ansprüche 1 bis 3, wobei der Überspannungsüberwachungseingang (10) über eine Reihenschaltung aus einem ersten Widerstand (12) und der ersten Diode (13) mit dem dritten Anschluss (23) verbunden ist.

5. Treiberschaltung (1) nach einem der Ansprüche 1 bis 4, wobei zwischen dem Bezugspotentialeingang (8) und dem Überspannungsüberwachungseingang (10) eine zweite Diode (16) und zwischen dem Überspannungsüberwachungseingang (10) und dem Steuerpotentialeingang (9) eine dritte Diode (17) angeordnet ist.

6. Treiberschaltung (1) nach einem der Ansprüche 1 bis 5, wobei das Schaltelement (15) in einem Teil des Verbindungspfads angeordnet ist, der zwischen der Kapazität (14) und dem dritten Anschluss (23) liegt.

7. Treiberschaltung (1) nach einem der Ansprüche 1 bis 6, wobei das Schaltelement (15) in einem Teil des Verbindungspfads angeordnet ist, der zwischen dem zweiten Anschluss (22) und der Kapazität (14) liegt.

8. Treiberschaltung (1) nach einem der Ansprüche 1 bis 7, wobei das Schaltelement (15) ein Halbleiterschalter ist, der einen Ansteuereingang (24) aufweist.

9. Treiberschaltung (1) nach Anspruch 8, wobei der Ansteuereingang (24) mit dem Steuerausgang (7) des Treiberbausteins (6) verbunden ist.

10. Schaltungsanordnung (30) umfassend eine Treiberschaltung (1) nach einem den Ansprüche 1 bis 9 und einen Leistungshalbleiterschalter (2) mit unidirektionaler Durchflussrichtung, wobei der erste Anschluss (21) mit dem Steueranschluss (3), der zweite Anschluss (22) mit dem Bezugspotentialanschluss (4) und der dritte Anschluss (23) mit dem gesteuerten Anschluss (5) des Leistungshalbleiterschalters (2) verbunden ist.

11. Schaltungsanordnung (30) nach Anspruch 10, wobei der Leistungshalbleiterschalter (2) ein IGBT ohne antiparallele Diode ist.

12. Bidirektionale Schaltungsanordnung (31) umfassend zwei Teilschaltungsanordnungen, die jeweils durch eine Schaltungsanordnung (30, 30') nach Anspruch 10 oder 11 gebildet sind, wobei die Leistungshalbleiterschalter (2, 2') der beiden Teilschaltungsanordnungen antiparallel geschaltet sind.

13. Bidirektionale Schaltungsanordnung (31) nach Anspruch 12, wobei die beiden Steuereinrichtungen (18, 18') der Teilschaltungsanordnungen derart eingerichtet sind, dass die Schaltelemente (15, 15') der Teilschaltungsanordnungen komplementär zueinander geöffnet und geschlossen werden.

14. Wechselrichter mit einer BSNPC-Brückenschaltung umfassend eine bidirektionale Schaltungsanordnung (31) nach Anspruch 12 oder 13.

## Claims

1. A driver circuit (1) for a power semiconductor switch (2) with a unidirectional flow direction comprising a control terminal (3), a reference potential terminal (4) and a controlled terminal (5), the driver circuit (1) comprising a driver module (6) with a control output (7), a reference potential input (8), and an overvoltage monitoring input (10), and wherein:
- the control output (7) is connected to a first terminal (21) provided for connection to the control terminal (3),
- the reference potential input (8) is connected to a second terminal (22) provided for connection to the reference potential terminal (4),
- the overvoltage monitoring input (10) is connected via a first diode (13) to a third terminal (23) provided for connection to the controlled terminal (5), and
- the overvoltage monitoring input (10) is connected to the reference potential input (8) via a capacitance (14),
**characterized in that**
a connection path from the second terminal (22) to the third terminal (23) via the capacitance (14) and the first diode (13) is switchable by an actively controllable switching element (15), wherein a control device (18) is provided that is configured to open the switching element (15) when the potential at the second terminal (22) is higher than the potential at the third terminal (23), and/or to close the switching element (15) when a control potential (Vcc) is present at the control output (7), and/or to open the switching element (15) when a reference potential (GND) is present at the control output (7).

2. The driver circuit (1) according to claim 1, wherein the driver module (6) is configured to selectively apply at the control output (7) either a reference potential (GND) applied at the reference potential input (8) or a control potential (Vcc) applied at a control potential input (9) of the driver module (6).

3. The driver circuit (1) according to any one of claims 1 to 2, wherein the driver module (6) is configured to detect an exceedance of a threshold value set within the driver module by a voltage at the overvoltage monitoring input (10) against the reference potential (GND).

4. The driver circuit (1) according to any one of claims 1 to 3, wherein the overvoltage monitoring input (10) is connected to the third terminal (23) via a series circuit comprising a first resistor (12) and the first diode (13).

5. The driver circuit (1) according to any one of claims 1 to 4, wherein a second diode (16) is arranged between the reference potential input (8) and the overvoltage monitoring input (10), and a third diode (17) is arranged between the overvoltage monitoring input (10) and the control potential input (9).

6. The driver circuit (1) according to any one of claims 1 to 5, wherein the switching element (15) is arranged in a portion of the connection path between the capacitance (14) and the third terminal (23).

7. The driver circuit (1) according to any one of claims 1 to 6, wherein the switching element (15) is arranged in a portion of the connection path between the second terminal (22) and the capacitance (14).

8. The driver circuit (1) according to any one of claims 1 to 7, wherein the switching element (15) is a semiconductor switch comprising a control input (24).

9. The driver circuit (1) according to claim 8, wherein the control input (24) is connected to the control output (7) of the driver module (6).

10. A circuit arrangement (30) comprising a driver circuit (1) according to any one of claims 1 to 9 and a power semiconductor switch (2) with unidirectional flow direction, wherein the first terminal (21) is connected to the control terminal (3), the second terminal (22) is connected to the reference potential terminal (4) and the third terminal (23) is connected to the controlled terminal (5) of the power semiconductor switch (2).

11. The circuit arrangement (30) according to claim 10, wherein the power semiconductor switch (2) is an IGBT without an antiparallel diode.

12. A bidirectional circuit arrangement (31) comprising two subcircuit arrangements each formed by a circuit arrangement (30, 30') according to claim 10 or 11, wherein the power semiconductor switches (2, 2') of the two subcircuit arrangements are connected in an antiparallel manner.

13. The bidirectional circuit arrangement (31) according to claim 12, wherein the two control devices (18, 18') of the subcircuit arrangements are arranged such that the switching elements (15, 15') of the subcircuit arrangements are opened and closed complementarily to one another.

14. An inverter with a BSNPC bridge circuit comprising a bidirectional circuit arrangement (31) according to claim 12 or 13.

## Revendications

1. Circuit de pilotage (1) pour un commutateur semiconducteur de puissance (2) avec sens de passage unidirectionnel, lequel possède une borne de commande (3), une borne de potentiel de référence (4) et une borne commandée (5), le circuit de pilotage (1) comportant un composant de pilotage (6), lequel possède une sortie de commande (7), une entrée de potentiel de référence (8) et une entrée de surveillance de surtension (10), et :
- la sortie de commande (7) étant reliée à une première borne (21) qui est destinée à être reliée à la borne de commande (3),
- l'entrée de potentiel de référence (8) étant reliée à une deuxième borne (22) qui est destinée à être reliée à la borne de potentiel de référence (4),
- l'entrée de surveillance de surtension (10) étant reliée par le biais d'une première diode (13) à une troisième borne (23) qui est destinée à être reliée à la borne commandée (5), et
- l'entrée de surveillance de surtension (10) étant reliée par le biais d'un condensateur (14) à l'entrée de potentiel de référence (8),
**caractérisé en ce que**
un trajet de liaison de la deuxième borne (22) à la troisième borne (23) passant par le condensateur (14) et la première diode (13) peut être commuté par un élément de commutation (15) pilotable activement, un dispositif de commande (18) étant présent, lequel est conçu pour ouvrir l'élément de commutation (15) lorsque le potentiel au niveau de la deuxième borne (22) est supérieur au potentiel au niveau de la troisième borne (23) et/ou pour fermer l'élément de commutation (15) lorsque un potentiel de commande (Vcc) est présent à la sortie de commande (7) et/ou pour ouvrir l'élément de commutation (15) lorsque un potentiel de référence (GND) est présent à la sortie de commande (7).

2. Circuit de pilotage (1) selon la revendication 1, le composant de pilotage (6) étant conçu pour appliquer à la sortie de commande (7), au choix, un potentiel de référence (GND) présent à l'entrée de potentiel de référence (8) ou un potentiel de commande (Vcc) présent à une entrée de potentiel de commande (9) du composant de pilotage (6).

3. Circuit de pilotage (1) selon l'une des revendications 1 à 2, le composant de pilotage (6) étant conçu pour détecter un dépassement d'une valeur de seuil réglée à l'intérieur du composant de pilotage par une tension appliquée à l'entrée de surveillance de surtension (10) par rapport au potentiel de référence (GND).

4. Circuit de pilotage (1) selon l'une des revendications 1 à 3, l'entrée de surveillance de surtension (10) étant reliée à la troisième borne (23) par le biais d'un circuit série constitué d'une première résistance (12) et de la première diode (13).

5. Circuit de pilotage (1) selon l'une des revendications 1 à 4, une deuxième diode (16) étant disposée entre l'entrée de potentiel de référence (8) et l'entrée de surveillance de surtension (10) et une troisième diode (17) entre l'entrée de surveillance de surtension (10) et l'entrée de potentiel de commande (9) .

6. Circuit de pilotage (1) selon l'une des revendications 1 à 5, l'élément de commutation (15) étant disposé dans une partie du trajet de liaison qui se trouve entre le condensateur (14) et la troisième borne (23).

7. Circuit de pilotage (1) selon l'une des revendications 1 à 6, l'élément de commutation (15) étant disposé dans une partie du trajet de liaison qui se trouve entre la deuxième borne (22) et le condensateur (14).

8. Circuit de pilotage (1) selon l'une des revendications 1 à 7, l'élément de commutation (15) étant un commutateur semiconducteur qui possède une entrée de commande (24).

9. Circuit de pilotage (1) selon la revendication 8, l'entrée de commande (24) étant reliée à la sortie de commande (7) du composant de pilotage (6) .

10. Arrangement de circuit (30) comprenant un circuit de pilotage (1) selon l'une des revendications 1 à 9 et un commutateur semiconducteur de puissance (2) avec sens de passage unidirectionnel, la première borne (21) étant reliée à la borne de commande (3), la deuxième borne (22) à la borne de potentiel de référence (4) et la troisième borne (23) à la borne commandée (5) du commutateur semiconducteur de puissance (2).

11. Arrangement de circuit (30) selon la revendication 10, le commutateur semiconducteur de puissance (2) étant un IGBT sans diode en tête-bêche.

12. Arrangement de circuit bidirectionnel (31) comprenant deux arrangements de circuit partiel, lesquels sont respectivement formés par un arrangement de circuit (30, 30') selon la revendication 10 ou 11, les commutateurs semiconducteurs de puissance (2, 2') des deux arrangements de circuit partiel étant branchés en tête-bêche.

13. Arrangement de circuit bidirectionnel (31) selon la revendication 12, les deux dispositifs de commande (18, 18') des arrangements de circuit partiel étant conçus de telle sorte que les éléments de commutation (15, 15') des arrangements de circuit partiel sont ouverts et fermés de manière complémentaire l'un par rapport à l'autre.

14. Onduleur comprenant un circuit en pont à BSNPC, comportant un arrangement de circuit (31) selon la revendication 12 ou 13.
